# EUROPÄISCHE PATENTSCHRIFT

(11) **EP 0 370 996 B1**
(45) Veröffentlichungstag und Bekanntmachung des Hinweises auf die Patenterteilung: **12.01.1994**
(21) Anmeldenummer: 89890267.1
(22) Anmeldetag: 10.10.1989
(51) Int. Cl.: H03H 9/17, H01L 41/18

(54) **Piezoelektrisches Kristallelement auf der Basis von GaP04**
Piezoelectric crystal element based in GaPO4
Elément cristallin piezoélectrique à base de GaPO4

(30) Priorität: 25.11.1988 AT 2909/88
(43) Veröffentlichungstag der Anmeldung: 30.05.1990
(73) Patentinhaber: AVL Gesellschaft für Verbrennungskraftmaschinen und Messtechnik mbH.Prof.Dr.Dr.h.c. Hans List, 8020 Graz (AT)
(72) Erfinder: Engel, Günter, Dipl.-Ing.Dr., A-8430 Leitring (AT); Krempl, Peter W., Dr., A-8047 Graz/Ragnitz (AT); Stadler, Josef Michael, Dipl.-Ing., A-8055 Graz (AT)
(74) Vertreter: Krause, Walter, Dr. Dipl.-Ing.

(56) Entgegenhaltungen:
- AT-A- 379 831
- US-A- 4 625 138
- PROCEEDINGS OF THE NAL ELECTR. CONF., Band 35, Oktober 1981, Seiten 340-346, Oak Brook, Illinois, US; J.F. VETELINO: "Methods for temperature compensation in saw devices"
- JOURNAL OF CRYSTAL GROWTH, Band 80, 1987, Seiten 340-346, Elsevier Science Publishers B.V., Amsterdam, NL; J.C. JUMAS et al.: "Crystal growth of berlinite, ALPO4: Physical characterization and comparison with quartz"

## Beschreibung

Die Erfindung betrifft ein Piezoelektrisches Kristallelement auf der Basis von GaPO₄, vorzugsweise für Resonatoranwendungen, mit planparallelen plankonvexen oder bikonvexen Deckflächen ggf. zur Anbringung von Elektroden und einer parallel zu einer planen oder symmetrisch zu den bikonvexen Deckflächen liegenden Hauptebene.

Wie bereits in der EP-A-069 112 beschrieben, ist es bekannt, dap quarzhomöotype Kristalle der Punktsymmetrieklasse 32 mit der chemischen Summenformel ABO₄ insbesondere piezoelektrische Kristalle aus der Gruppe GaAsO₄, GaPO₄, AlAsO₄, FeAsO₄, FePO₄, MnPO₄ und MnAsO₄ eine hervorragende Temperaturbeständigkeit bezüglich wichtiger physikalischer Eigenschaften der Kristalle, insbesondere der piezoelektrischen und elastischen Parameter aufweisen, was deren bevorzugten Einsatz in piezoelektrischen Resonatoren zugute kommt. Die günstigen Eigenschaften dieser Kristalle hängen mit einem besonderen Kennzeichen des Phononenspektrums zusammen, wobei im Temperaturbereich von 20 bis 500°C für die niedrigste Frequenz des totalsymmetrischen Phononen-Modes eine Frequenzverschiebung um höchstens 15 % beobachtet wird. Es werden eine ganze Reihe von Anwendungsmöglichkeiten dieser Kristallelemente dargestellt, wobei vor allem auf die GaPO₄ näher eingegangen wird.

Weiters ist es bekannt, daß die genannten Kristalle auf hydrothermalem Weg synthetisch herstellbar sind, was z.B. in der AT-PS 379 831 beschrieben ist.

Für piezoelektrische Resonatoren mit Kristallen von trigonaler Symmetrie - also auch z.B. LiNbO₃ - ist es ganz allgemein bekannt, Dicken - Scherungs - Schwingungen auszunützen; im speziellen sind solche Anwendungen auch für α-Quarz und α-AlPO₄ bekanntgeworden, wobei darauf hingewiesen wird, daß diese Kristalle nicht im selben Maße als hochtemperaturstabil anzusehen sind, wie z.B. GaPO₄ und auch das obenangeführte Merkmal des Phononenspektrums hier nicht zutrifft.

Eine übersichtliche Zusammenfassung zahlreicher Methoden und Aspekte der Fertigung von Resonatoren aus Quarz ist z.B. aus "Quarz Vibrators and their Applications" (P.Vigoureux, His Majesty's Stationary Office, London, 1950) enthalten.

Für Anwendungen der genannten Dicken- Scherungs-Schwingungen sind in der Literatur sowohl für Quarz als auch für AlPO₄ spezielle vorteilhafte Schnittwinkel, sogenannte gedrehte Y-Schnitte angegeben, welche beim Schneiden der Kristallelemente aus dem Rohkristallbarren von Bedeutung sind. Beschrieben sind diese Schnittwinkel für Quarz im bereits genannten Buch "Quarz Vibrators and their Applications", für AlPO₄ z.B. in Crystal Growth Vol.80 1987 Seiten 133 bis 148, J.C. Jumas et al.

Überraschenderweise haben sich nun - trotz derselben Kristallstruktur - bei Kristallen aus GaPO₄ diese Schnittwinkel bzw. Schnittebenen als zwar machbar, nicht jedoch als optimal herausgestellt. Einerseits liegen die bekannten Schnittebenen in eher schlechter Relation zu den makroskopisch an den Rohkristallbarren erkennbaren Winkelwerten zwischen Wachstumslächen und den kristallographischen Achsen, andererseits wird durch diese Schnittebenen die theoretisch mögliche elektromechanische Kopplung nicht genügend ausgenützt, wobei außerdem ein negativer Temperaturkoeffizient der Resonatorfrequenzen auftritt.

Die der Erfindung zugrundeliegende Aufgabe besteht nun einerseits darin für piezoelektrische Kristallelemente auf der Basis von GaPO₄ Schnittebenen anzugeben, welche erstens eine relativ einfache Justierung anhand der mit gegenwertigen Züchtungsverfahren erzielbaren Rohkristallbarren erlauben und zweitens im Bereich der Raumtemperatur leicht positive Temperaturkoeffizienten der Resonanzfrequenzen, sowie eine geringe Nebenwellenanfälligkeit aufweisen, und andererseits neue Kristalle auf der Basis von GaPO₄ anzugeben, welche im selben Schnittwinkelbereich die genannten Eigenschaften im wesentlichen beibehalten.

Diese Aufgabe wird erfindungsgemäß dadurch gelöst, daß die Hauptebene des Kristallelementes parallel zu einer Schnittebene verläuft, welche aus einer zur optischen Achse (c) parallel liegenden hexagonalen Prismenfläche eines Rohkristallbarrens durch Drehung um eine der zweizähligen kristallographischen Symmetrieachsen (a₁, a₂, oder a₃) um einen Winkel ϑ zwischen -5° und -22° hervorgeht. Stellt man sich den Rohkristallbarren eingebettet in ein rechtwinkeliges Koordinatensystem mit den Achsen X, Y, Z vor, dergestalt, daß eine der zweizähligen Symmetrieachsen a₁ parallel zur X-Achse und die dreizählige Symmetrieachse c (optische Achse) parallel zur Z-Achse verläuft, so liegen alle hexagonalen Prismenflächen parallel zur Z-Achse. Ausgehend von einer der hexagonalen Prismenflächen ist nun der Rohkristallbarren um einen Winkel ϑ zwischen -5 und -22° um die X-Achse zu kippen, um die Deckflächen der auszuschneidenden Kristallelemente in die Schnittebene zu drehen.

Besonders vorteilhaft ist es, wenn in einer Weiterbildung der Erfindung der Winkel ϑ zwischen -13° und -17° liegt.

Die positiven Eigenschaften des piezoelektrischen Kristallelementes werden erfindungsgemäß auch dann beibehalten, wenn für die zur Hauptebene des Kristallelementes parallel verlaufende Schnittebene vor deren Drehung um eine der zweizähligen kristallographischen Symmetrieachsen eine Drehung um die optische Achse um einen Winkel β zwischen -5° und 5° zugelassen wird. Insbesondere zur Erleichterung der Justierung vor dem Schneiden können leichte Verkippungen der Drehachse ohne weiteres in Kauf genommen werden.

Überraschenderweise hat sich gezeigt, daß die vorgeschlagene Schnittebene bzw. Schnittwinkel nicht nur für die Reinsubstanz GaPO₄ gelten, sondern daß in einer Weiterbildung der Erfindung das Kristallelement aus einem Kristall der Summenformel Ga₁₋ ₓMₓPO₄ bestehen kann, worin M für ein dreiwertiges Element steht und 0 ≦ x < o,5 gilt. Es sind somit auch Mischkristalle einsetzbar, welche aus der Reinsubstanz dadurch entstehen, daß die Hälfte der Ga-Atome durch ein dreiwertiges Element ersetzt werden. Erfindungsgemäß ergeben sich vor allem dann vorteile, wenn Gallium zum Teil durch Aluminium ersetzt wird, da Aluminium wesentlich billiger kommt und beim dargelegten Mischungsverhältnis die positiven Eigenschaften vom GaPO₄ weitestgehend erhalten bleiben.

Die Erfindung wird im folgenden anhand von Zeichnungen näher beschrieben. Es zeigen:
- Figur 1: ein erfindungsgemäßes Kristallelement samt Rohkristallbarren,
- Figur 2: einen Schnitt entlang der Y-Z-Ebene nach Fig. 1,
- Figur 3, 4 und 5: Meßkurven des piezoelektrischen Kristallelementes sowie
- Figur 6: eine bevorzugte Anordnung der Ableitelektroden relativ zu den kristallographischen Achsen.

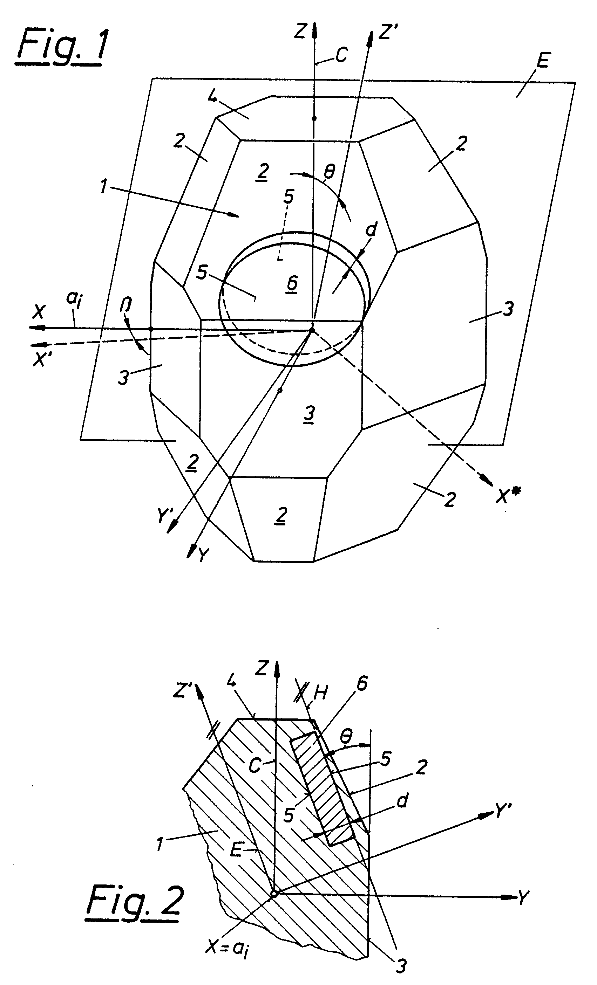

Mit den üblichen Züchtungstechniken für Kristalle auf der Basis von GaPO₄ erhält man Rohkristallbarren 1, welche einen ausgeprägten Habitus mit trigonalen Rhomboederflächen 2, hexagonalen Prismenflächen 3, sowie Pinacoidflächen 4 aufweisen. Dies ist in den Fig. 1 und 2 verdeutlicht, wo ein typischer Rohkristallbarren schematisch dargestellt ist. Zum Zweck der leichteren Definition von Schnittwinkeln bzw. der Schnittebene E sind die Achsen des rechtwinkeligen Koordinatensystems X, Y, Z welches wie folgt mit den zweizähligen kristallographischen Symmetrieachsen a₁ (i=1-3) und der optischen Achse c (dreizählige Symmetrieachse) zusammenhängt, dargestellt. X ist parallel zu einer der Achsen a₁ derart, daß ihre Richtung durch das positive Vorzeichen der durch den piezoelektrischen Effekt entstehenden Ladung gegeben ist, wobei bei einem optisch linksdrehenden Kristall Druck, bei einem optisch rechtsdrehenden Kristall Zug anzuwenden ist. Die Z-Achse ist parallel zur optischen Achse c und Y ergibt sich als senkrecht zu X und Z derart, daß ein Rechtssystem der Achsen gebildet wird. Die Y-Achse entspricht somit keiner der kristallographischen Symmetrieachsen. Mit X* ist eine weitere mögliche X-Achse bezeichnet. Die planparallelen Deckflächen 5 eines scheibchenförmigen piezoelektrischen Kristallelementes 6 liegen parallel zur Hauptebene H sowie parallel zur Schnittebene E, welche mit der zur Z-Achse parallelen hexagonalen Prismenfläche 3 einen Winkel ϑ zwischen -5° und -22° einschließt. Aus Fig. 2 ist deutlich ersichtlich, daß eine die plane Deckfläche 5 des Kristallelementes 6 beinhaltende Hauptebene H parallel zur Schnittebene E liegt. Bei plankonvexer Ausbildung des Kristallelementes liegt die Hauptebene parallel zur planen Deckfläche, bei bikonvexer Ausbildung fällt die Hauptebene mit der Symmetrieebene zusammen.

Kristallschnitte mit der Dickenrichtung (Dicke d definiert als kleinste Dimension) in Richtung der Y-Achse nennt man Y-Schnitte. Denkt man sich nun einen solchen Y-Schnitt um die X-Achse um den Winkel ϑ im Uhrzeigersinn verdreht, so entsteht ein gedrehter Y-Schnitt. Derartige Schnitte haben für Resonatoren aus Kristallen mit trigonaler Symmetrie große Bedeutung, da bei ihnen nur eine der drei möglichen akustischen Resonanzwellen piezoelektrisch anregbar ist.

Als bekannte Beispiele können Quarz und Berlinit (α-SiO₂ und α-AlPO₄ angeführt werden: Bei ersterem ist der sogenannte AT-Schnitt bei etwa ϑ = -35°, der CT-SAchnitt bei -38°, bei letzterem ein ebenfalls als AT-Schnitt bezeichneter bei ϑ = -30°.

Naheliegend wäre nun, aufgrund derselben Kristallstruktur, entsprechende Kristallschnitte von GaPO₄ im Bereich von etwa -30 bis -40° zu verwenden. Der Temperaturkoeffizient der Resonanzfrequenzen von solchen Kristallschnitten beträgt jedoch etwa -15 bis -30 ppm/K, was sowohl betragsmäßig als auch vom Vorzeichen her ungünstig ist. Außerdem hat man dabei aufgrund des typischen Habitus gemäß Fig. 1 vor allem bei kleineren Rohkristallbarren (z.B. < 10g Gewicht) ein ungünstiges Verhältnis von Ausbeute zum Verschnitt, kaum eine Hilfe zur Vororientierung bei der Kristallbearbeitung, und weiters recht niedrige Frequenzkonstanten von ca. 1100 KHzmm.

Wünschenswert sind demgegenüber Kristallelemente mit einem leicht positiven Temperaturkoeffizienten oder einem solchen nahe null, welche eine günstige Ausbeute aus den mit den gegenwärtigen Züchtungsverfahren erzielbaren Kristallen erlauben, welche weiters eine gewisse Hilfe bei der Orientierung des Kristalls bei der Kristallbearbeitung bieten und welche eine größere Frequenzkonstante besitzen.

Bei Auswahl eines gedrehten Y-Schnittes gemäß Anspruch 1 werden diese Anforderungen erfüllt. Die Temperaturkoeffizienten der Resonanzfrequenzen liegen für Umgebungstemperatur als Referenztemperatur auf beiden Seiten der Nullinie.

Wie weiters aus Fig. 2 ersichtlich, verbessert sich die Ausbeute an Kristallelementen insbesondere bei den Schnitten zwischen -20° und -22°, da der Winkel der Rhomoederfläche 2 zur gedachten Verlängerung der hexagonalen Prismenfläche 3 21.02° beträgt. Dies ergibt auch offensichtlich eine Hilfe bei der Orientierung, da die erste Einstellung bei der Kristallbearbeitung auf diese Fläche erfolgen kann, und für das Zurückdrehen zu den bevorzugten Winkelwerten die hexagonale Prismenfläche als Maß dienen kann. Zudem liegen die Frequenzkonstanten im Bereich von ca. 1240 bis 1440 KHzmm, was in Anbetracht der hohen Dichte des Materials durchaus ein beachtlicher Wert ist.

Da sich auch Wachstumszonengrenzen im Bereich unter den Ableitelektroden ungünstig auf das Schwingungsverhalten auswirken können, ist vorgesehen, daß zonenreines Kristallmaterial zur Verwendung kommt. An Zonengrenzen tritt erstens eine Häufung von linearen Kristalldefekten auf, zweitens sind geringfügige Verkippungen der Kristallachsen der durch die Zonengrenzen geteilten Bereiche möglich, was sich beides ungünstig auf das elastische und piezoelektrische Verhalten auswirkt. Im Prinzip kann jede Wachstumszone verwendet werden, zu bevorzugen sind allerdings die Z-Zone (Wachstum an der Pinacoidfläche 4) oder die R-Zone (Wachstum an der Rhomboederfläche 2). Eine weitere Verbesserung kann erreicht werden, wenn zusätzlich die Infrarotabsorption α des Rohkristallbarrens im Wellenlängenbereich von 3µm einen Wert von weniger als 0.8cm⁻¹ aufweist. In diesem Fall ist eine ausreichend gute Bearbeitbarkeit des Kristalls (Schneiden, Läppen, Polieren) gegeben, und ferner die Resonatorgüte nicht mehr zum überwiegenden Teil durch die Dämpfung im Kristall bestimmt, was insbesondere für Werte, die groß gegenüber dem oben angegebenen α - Grenzwert sind, gilt. Da der Wert α proportional dem Fremdinhalt an Wasserspuren im Kristall ist, bestimmt somit dieser Wasserinhalt auch die Größe der viskoelastischen Dämpfung im Kristall.

Günstig ist ferner die Beachtung einer hohen Qualität der Oberflächen. Eine geläppte Oberfläche des Kristallelementes ist zwar durchaus ausreichend, die besten Resultate werden aber mit polierten Oberflächen erzielt. Im ersteren Fall ist die Elektrodenhaftung besser, im zweiten Fall ist die Resonatorgüte im allgemeinen höher.

Betrachtet man nochmals Fig. 1, so ist bezüglich der geometrischen Toleranzen zu sagen, daß die X-Achse und die entsprechende zweizählige Symmetrieachse a₁ nicht exakt zusammenfallen müssen, ein kleiner Spielraum von ca. β = -5 bis +5° Neigung in eine Lage X′ in der X-Y-Ebene ist durchaus möglich, ohne daß eine wesentliche Änderung der Verhältnisse eintritt. Das um den Winkel ϑ verkippte Koordinatensystem ist mit Y′, Z′ bezeichnet.

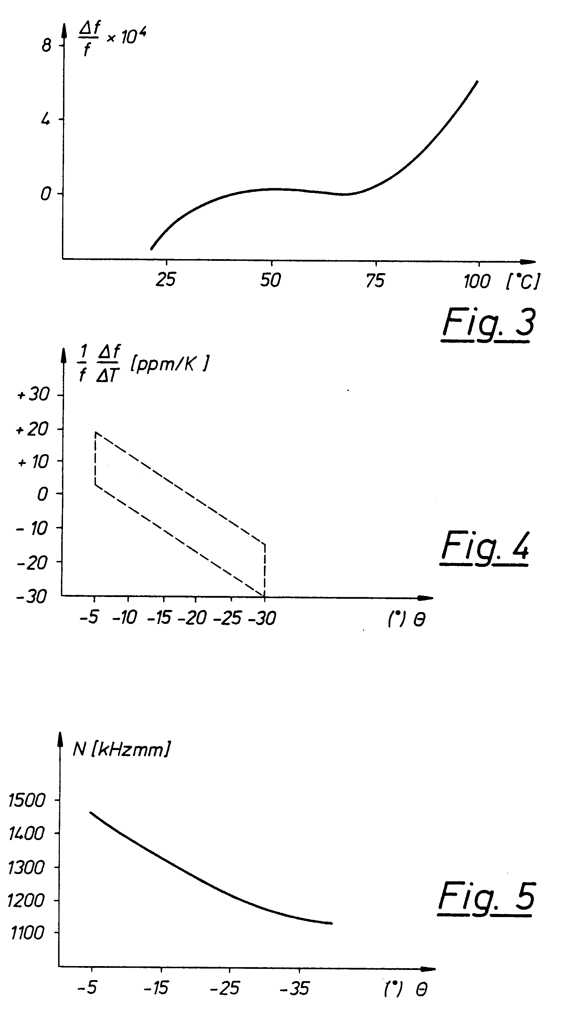

Die relative Frequenzänderung f/f in Abhängigkeit von der Temperatur T in °C eines erfindungsgemäßen Kristallelementes aus GaPO₄ ist in Fig. 3 dargestellt. Besonders gute Werte sind im Bereich zwischen 25 und 75° C zu erwarten.

Fig. 4 zeigt die ermittelte Abhängigkeit des Temperaturkoeffizienten vom Schnittwinkel ϑ für einen Temperaturbereich von 25 bis 50° C, Fig. 5 die Abhängigkeit der Frequenzkonstante N in KHZmm vom Winkel ϑ der Schnittebene für Kristallelemente auf der Basis von GaPO₄.

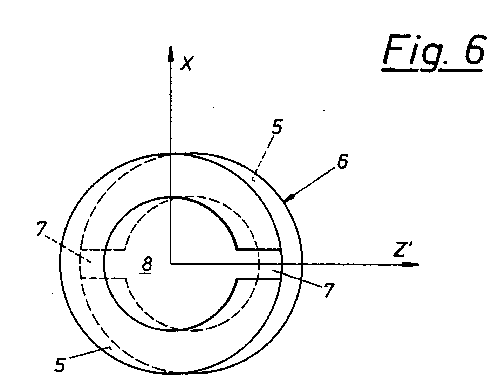

Um möglichst zu vermeiden, daß sich die Elektrodenbrücken 7 der Ableitelektroden 8 auf das Schwingungsverhalten des Reso nators auswirken, ist entsprechend Fig. 6 vorgesehen, diese entlang der Z′-Achse anzuordnen.

## Patentansprüche

1. Piezoelektrisches Kristallelement auf der Basis von GaPO₄, vorzugsweise für Resonatoranwendungen, mit planparallelen plankonvexen oder bikonvexen Deckflächen ggf. zur Anbringung von Elektroden und einer parallel zu einer planen oder symmetrisch zu den bikonvexen Deckflächen liegenden Hauptebene, **dadurch gekennzeichnet**, daß die Hauptebene (H) des Kristallelementes (6) parallel zu einer Schnittebene (E) verläuft, welche aus einer zur optischen Achse (c) parallel liegenden hexagonalen Prismenfläche (3) eines Rohkristallbarrens (1) durch Drehung um eine der zweizähligen kristallographischen Symmetrieachsen (a₁, a₂, oder a₃) um einen Winkel ϑ zwischen -5° und -22° hervorgeht.

2. Piezoelektrisches Kristallelement nach Anspruch 1, **dadurch gekennzeichnet,** daß der Winkel ϑ zwischen -13° und -17° liegt.

3. Piezoelektrisches Kristallelement nach Anspruch 1 oder 2, **dadurch gekennzeichnet**, daß für die zur Hauptebene (H) des Kristallelementes (6) parallel verlaufende Schnittebene (E) vor deren Drehung um eine der zweizähligen kristallographischen Symmetrieachsen (a₁, a₂ oder a₃) eine Drehung um die optische Achse (c) um einen Winkel β zwischen -5 und 5° zulässig ist.

4. Piezoelektrisches Kristallelement nach einem der Ansprüche 1 bis 3, **dadurch gekennzeichnet**, daß das Kristallelement (6) aus einem Kristall der Summenformel Ga₁-ₓMₓPO₄ besteht, worin M für ein dreiwertiges Element steht und 0 ≦ x < 0,5 gilt.

5. Piezoelektrisches Kirstallelement nach Anspruch 4, **dadurch gekennzeichnet**, daß M für Aluminium steht.

## Claims

1. A piezoelectric crystal element on the basis of GaPO₄, preferably for resonator applications, with plane-parallel, plane-convex or bi-convex top and bottom faces, possibly for attaching electrodes, and with a principal plane lying parallel to one of the plane faces or symmetrical to the bi-convex faces, **wherein** the principal plane H of the crystal element 6 runs parallel to a cutting plane E, which cutting plane E is generated by rotating a hexagonal prism face 3 of a raw crystal bar 1, which is parallel to the optical axis c, around one of the two-fold crystallographic symmetry axes (a₁, a₂, or a₃) through an angle ϑ of -5° to -20°.

2. A piezoelectric crystal element according to claim 1, **wherein** the angle ϑ is between -13° and -17°.

3. A piezoelectric crystal element according to claim 1 or 2, **wherein** the cutting plane E parallel to the principal plane H of the crystal element 6 is permitted to rotate around the optical axis c through an angle β of -5° to +5° prior to its rotation around one of the two-fold crystallographic symmetry axes (a₁, a₂, or a₃).

4. A piezoelectric crystal element according to any of claims 1-3, **wherein** the crystal element 6 is cut from a crystal whose total formula is Ga₁₋ₓMₓPO₄, M standing for a trivalent element and x satisfying 0 ≦ x < 0.5.

5. A piezoelectric crystal element according to claim 4, **wherein** M stands for aluminium.

## Revendications

1. Elément de cristal piézo-électrique à base de GaPO₄, de préférence pour des applications de résonateur avec des surfaces de recouvrement planes et parallèles, planes et convexes ou biconvexes le cas échéant pour pouvoir fixer des électrodes, et avec un plan principal parallèle à une surface de recouvrement plane ou symétrique par rapport aux surfaces de recouvrement biconvexes, caractérisé en ce que le plan principal (H) de l'élément de cristal (6) s'étend parallèlement à un plan de coupe (E) qui est déterminé par rotation d'un angle ϑ compris entre -5° et -22° autour d'un axe de symétrie cristallographique d'ordre Z (a₁, a₂ ou a₃) d'une face prismatique hexagonale (3) d'une barre de cristal brut (1) située parallèlement à l'axe optique (C).

2. Elément de cristal piézo-électrique selon la revendication 1, caractérisé en ce que l'angle ϑ est compris entre -13° et 17°.

3. Elément de cristal piézo-électrique selon la revendication 1 ou 2, caractérisé en ce qu'une rotation d'un angle β compris entre -5 et 5° est possible autour de l'axe optique (C) pour le plan de coupe (3) s'étendant parallèlement au plan principal (H) de l'élément de cristal (6) avant sa rotation autour d'un axe de symétrie cristallographique (a₁, a₂ ou a₃) d'ordre deux.

4. Elément de cristal piézo-électrique selon l'une des revendications 1 à 3, caractérisé en ce que l'élément de cristal (6) est constitué d'un cristal de formule globale Ga₁₋ₓMₓPO₄, dans laquelle M est un élément trivalent et 0 ≦ x < 0,5.

5. Elément de cristal piézo-électrique selon la revendication 4, caractérisé en ce que M est l'aluminium.
